# EUROPÄISCHE PATENTSCHRIFT

(11) **EP 1 208 610 B1**
(45) Veröffentlichungstag und Bekanntmachung des Hinweises auf die Patenterteilung: **01.06.2005**
(21) Anmeldenummer: 00962204.4
(22) Anmeldetag: 04.08.2000
(51) Int. Cl.: H01L 41/09

(54) **PIEZOELEKTRISCHER BIEGEWANDLER**
PIEZOELECTRIC BENDING TRANSDUCER
CONVERTISSEUR A FLEXION PIEZO-ELECTRIQUE

(30) Priorität: 30.08.1999 DE 19941112
(43) Veröffentlichungstag der Anmeldung: 29.05.2002
(73) Patentinhaber: Argillon GmbH, 96257 Redwitz (DE)
(72) Erfinder: BIESENECKER, Horst, D-96277 Schneckenlohe (DE); RIEDEL, Michael, D-96472 Rödental (DE)
(74) Vertreter: Tergau & Pohl Patentanwälte
(86) Internationale Anmeldenummer: PCT/DE2000/002613
(87) Internationale Veröffentlichungsnummer: WO 2001/017039

(56) Entgegenhaltungen:
- WO-A-96/41384
- PATENT ABSTRACTS OF JAPAN vol. 015, no. 121 (E-1049), 25. März 1991 (1991-03-25) & JP 03 009519 A (TOSOH CORP), 17. Januar 1991 (1991-01-17)

## Beschreibung

Die Erfindung betrifft einen piezoelektrischen Biegewandler mit verringerter thermischer Eigenverbiegung.

Ein derartiger Biegewandler ist beispielsweise aus der WO 96/41384 A1 bekannt. Der dort gezeigte Biegewandler umfaßt einen Tragkörper und eine auf den Tragkörper zumindest einseitig aufgebrachte piezoelektrisch aktive Schicht aus einer Piezokeramik. Zur Kompensation der thermischen Eigenverbiegung wird vorgeschlagen, für die Piezokeramik und für den Tragkörper Materialien mit im wesentlichen gleichen thermischen Ausdehnungskoeffizienten zu verwenden.

Ein piezoelektrischer Biegewandler mit einer auf einen Tragkörper aufgebrachten piezoelektrischen Schicht dient vorrangig zur Ausnutzung des indirekten oder reziproken piezoelektrischen Effekts, d.h. zur Umwandlung von elektrischer in mechanische Energie. Für einen Biegewandler gibt es eine Vielzahl von technischen Anwendungen. Solche Anwendungen sind z.B. als piezoelektrischer Druckkopf für einen Tintenstrahldrucker, als Schallaufnehmer oder -erzeuger für Mikrophone bzw. Lautsprecher, als Sensor für die Beschleunigungs- oder Druckmessung, als Stellelement in Braille-Zeilen, in Lesegeräten für Blinde, in Textilmaschinen, in Ventilen, in schreibenden Meßgeräten oder in berührungslosen Oberflächenmeßinstrumenten.

Insbesondere dann, wenn die durch den Biegewandler erbrachte Auslenkung klein ist (10 bis 200 µm), kann eine bei Temperaturänderung auftretende thermische Eigenverbiegung zum Ausfall eines mit einem Biegewandler betriebenen Systems führen. Ein Biegewandler mit einer sehr geringen thermischen Eigenverbiegung wird beispielsweise bei Anwendung in Ventilen, insbesondere in Pneumatik-Ventilen, gefordert. Kommt es hier zu einer nicht mehr tolerierbaren Eigenverbiegung des Biegewandlers bei Temperaturänderung, so ist beispielsweise die Schließfunktion des Ventils nicht mehr gewährleistet.

Nachteiligerweise bleibt jedoch auch mit dem in der WO 96/41384 A1 vorgeschlagenen Biegewandler eine Eigenverbiegung von einigen µm/10 °K bestehen. Eine solche Eigenverbiegung ist bei einer Anwendung in der Ventiltechnik nicht mehr tolerierbar. In der bisherigen Praxis werden daher Biegewandler durch Selektion aus der Fertigungscharge für die jeweilige Anwendung gefunden. Diese Methode ist jedoch sehr aufwendig und hat darüber hinaus den Nachteil, daß ein hoher Fertigungsausschuß unvermeidbar ist. Biegewandler mit einer Eigenverbiegung außerhalb des Toleranzbereiches können nicht eingesetzt werden und sind daher Ausschuß.

Der Erfindung liegt die Aufgabe zugrunde, einen piezoelektrischen Biegewandler mit einer gegenüber dem Stand der Technik noch weiter verringerten thermischen Eigenverbiegung anzugeben, der sich ohne hohen Fertigungsausschuß herstellen läßt.

Diese Aufgabe wird bei einem piezoelektrischen Biegewandler der eingangs genannten Art mit einem Tragkörper und einer auf den Tragkörper zumindest einseitig aufgebrachten piezoelektrisch aktiven Schicht erfindungsgemäß dadurch gelöst, daß auf die piezoelektrisch aktive Schicht, gegebenenfalls unter Zwischenlage einer Elektrode, eine Anpaßschicht mit einem vorgegebenen Volumen aufgebracht ist.

Die Erfindung geht dabei von der Überlegung aus, daß bei den bisherigen Selektionsverfahren zum Auffinden derjenigen Biegewandler einer Charge, die die geforderte geringe thermische Eigenverbiegung aufweisen, der Temperaturgang, d.h. die Eigenverbiegung pro °K bestimmt werden muß. Die Erfindung geht nun weiter von der Überlegung aus, daß nach Bestimmung des Temperaturgangs oder des Temperaturkoeffizienten der Eigenverbiegung die Eigenverbiegung dadurch kompensiert oder verringert werden kann, daß eine geeignete Anpaßschicht zusätzlich auf den Biegewandler aufgebracht wird. In einem weiteren Schritt wird nun die Verringerung oder Kompensation der Eigenverbiegung über das Volumen der aufgebrachten Anpaßschicht erreicht.

Dabei spielt es für die Erfindung keine Rolle, aus welchem Material letztlich die Anpaßschicht besteht. Das Material sollte lediglich leicht handhabbar sein und sich gut mit dem Material des Biegewandlers verbinden lassen. Mit anderen Worten sollte sich eine feste und dauerhafte Verbindung der Anpaßschicht mit dem Biegewandler erzielen lassen.

Die Kompensation der Eigenverbiegung läßt sich sowohl mit einer Anpaßschicht mit geringem thermischen Ausdehnungskoeffizienten als auch mit einer Anpaßschicht mit hohem thermischen Ausdehnungskoeffizienten erzielen. Zur Kompensation wird dann entweder mehr oder weniger Volumen der Anpaßschicht aufgetragen. Auch kann zur Kompensation der thermischen Eigenverbiegung die Anpaßschicht sowohl auf der bei Eigenverbiegung nach innen gekrümmten als auch auf der bei Eigenverbiegung nach Außen gekrümmten Seite des Biegewandlers aufgebracht werden.

Bei bekanntem Material der Anpaßschicht wird der Zusammenhang zwischen dem zur Kompensation der Eigenverbiegung aufzubringenden Volumen der Anpaßschicht und dem Temperaturgang eines vorgegebenen Biegewandler-Typs am besten empirisch ermittelt. Da die Biegewandler einer Charge unterschiedliche Eigenverbiegungswerte zeigen, läßt sich der angesprochene Zusammenhang leicht über eine einfache Meßreihe ausfindig machen.

Über das Volumen der Anpaßschicht kann nun für jeden Biegewandler der Eigenverbiegungswert auf den gewünschten Toleranzwert kompensiert werden. Die Erfindung erlaubt darüber hinaus, Biegewandler mit jeder beliebigen vorgegebenen thermischen Eigenverbiegung herzustellen.

Im übrigen läßt sich prinzipiell der Zusammenhang zwischen dem zur Kompensation der Eigenverbiegung aufzubringenden Volumen der Anpaßschicht und dem Temperaturgang des Biegewandlers aus der physikalischen Formel für die Volumendehnung mit Hilfe des kubischen Volumendehnungskoeffizienten herleiten.

Prinzipiell kann die Anpaßschicht natürlich auf beiden Seiten des Biegewandlers aufgebracht werden. Von Vorteil und wesentlich einfacher ist es jedoch, zur Kompensation der thermischen Eigenverbiegung die Anpaßschicht einseitig aufzubringen. Dies ist auch dann von Vorteil, wenn der piezoelektrische Biegewandler als ein sogenannter bimorpher Biegewandler ausgebildet ist, d.h. wenn die piezoelektrisch aktive Schicht beidseitig des Tragkörpers angeordnet ist.

Herstellungstechnisch ist es günstig, wenn die Eigenverbiegung des Biegewandlers über die Querschnittsfläche der Anpaßschicht kompensiert oder eingestellt wird. Praktisch wird dies dadurch realisiert, daß die gewünschte Kompensation der Eigenverbiegung bei gleicher Dicke der Anpaßschicht über die Länge und/oder die Breite des aufzubringenden Materials erzielt wird.

In vorteilhafter Weise wird die Anpaßschicht mittels Siebdruck aufgebracht. Selbstverständlich kann die Anpaßschicht natürlich auch in anderer Art und Weise auf den Biegewandler aufgebracht werden. Dies kann beispielsweise durch Kleben, Aufdampfen, Aufsputtern oder Aufsprühen geschehen.

Besonders von Vorteil ist es, wenn die Anpaßschicht ein siebdruckfähiger Kunststoff ist. Ein solcher Kunststoff läßt sich fertigungstechnisch in einfacher Art und Weise über das Siebdruckverfahren auf den Biegewandler auftragen. Über die Länge und Breite der aufgedruckten Anpaßschicht wird die Kompensation der Eigenverbiegung erzielt. Insbesondere läßt sich ein Epoxidharz auf diese Art und Weise leicht verarbeiten. Auch hat es sich gezeigt, daß Epoxidharz einen günstigen thermischen Ausdehnungskoeffizienten aufweist, so daß mit verhältnismäßig wenig Material die üblicherweise auftretenden Eigenverbiegungen der Biegewandler leicht kompensiert werden können.

In einer weiteren vorteilhaften Ausgestaltung der Erfindung ist die piezoelektrische Schicht eine Piezokeramik. Eine geeignete Piezokeramik ist beispielsweise eine sogenannte PZT-Keramik, worunter eine Blei-Zirkonat-Titan-Oxidkeramik verstanden wird. Eine derartige Piezokeramik erlaubt über ihre Zusammensetzung eine Anpassung an unterschiedliche Anforderungen. Durch Anlegen eines homogenen elektrischen Feldes wird eine polare Achse in der Piezokeramik erzeugt, die für das Auftreten des piezoelektrischen Effekts notwendig ist.

Das Trägermaterial des Tragkörpers spielt für die Erfindung eine lediglich untergeordnete Rolle. Für die mechanischen Eigenschaften des Biegewandlers hat sich jedoch insbesondere ein Faserverbundmaterial oder ein Metall als günstig erwiesen.

Ein Ausführungsbeispiel der Erfindung wird anhand einer Figur näher erläutert.

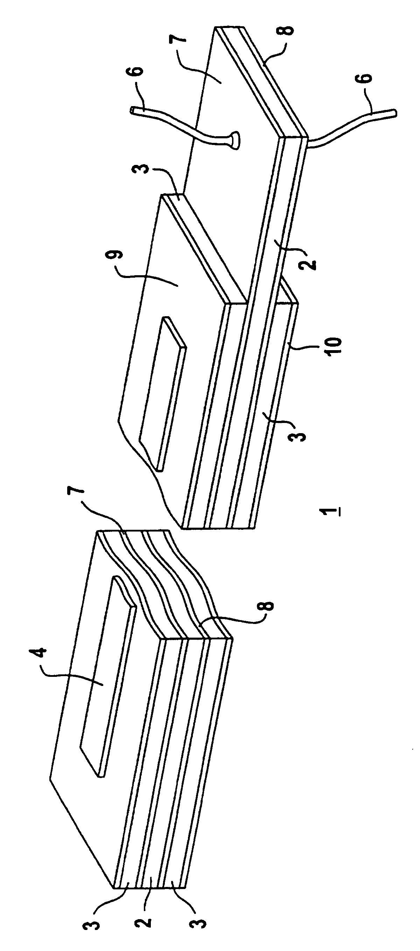

Die Figur zeigt einen bimorphen Biegewandler 1 mit einem Tragkörper 2 und mit einer darauf beidseitig aufgebrachten piezoelektrisch aktiven Schicht 3 aus einer Piezokeramik. Die Piezokeramik ist hierbei eine Blei-Zirkonat-Titan-Oxidkeramik. Der Tragkörper 2 ist ein mit Glas-, Kohle- oder aber mit Aramid-Fasern verstärktes Epoxidharz. Als Ausgangsmaterial für den Tragkörper 2 wurde ein Epoxidharz-Prepreg (ein noch nicht ausgehärteter Rohling) verwendet, welches durch eine Wärmebehandlung mit der Piezokeramik thermisch verklebt wurde. Auf eine Seite des Biegewandlers 1 ist eine Anpaßschicht 4 angeordnet. Die Anpaßschicht 4 besteht dabei aus einem Epoxidharz und wurde mittels des Siebdruckverfahrens aufgebracht.

Der Biegewandler 1 weist weiter elektrische Anschlüsse 6 auf, welche jeweils über einen Lötkontakt mit den innen liegenden, flächig aufgetragenen Elektroden 7 und 8 elektrisch verbunden sind. Die piezoelektrisch aktiven Schichten 3 weisen weiter ebenfalls flächig ausgeführte äußere Elektroden 9 und 10 auf. Die inneren Elektroden 7 und 8 sind zur elektrischen Kontaktierung des Biegewandlers 1 auf den freien Teil des Tragkörpers 2 geführt.

Alternativ und hier nicht dargestellt, kann zwischen den inneren Elektroden 7 und 8 und dem Tragkörper 2 an den Stellen, an welchen die piezoelektrisch aktiven Schichten 3 aufgelegt sind, eine weitere elektrisch leitfähige Schicht, welche als ein Gewebe oder in Form von parallelen Stegen ausgebildet ist, eingelegt sein. Dies erhöht die Ausfallsicherheit des piezoelektrischen Biegewandlers 1.

Der Biegewandler 1 weist insgesamt eine Länge von 25 mm, eine Breite von 7 mm und eine Dicke von 0,5 mm auf. Die Dicke der Blei-Zirkonat-Titan-Oxidkeramik beträgt dabei 0,13 mm.

Bei einem solchen Biegewandler 1 haben sich Schwankungen der Eigenverbiegung zwischen 1 und 5 µm/10 °K ergeben. ±4 µm/10 °K thermische Eigenverbiegung lassen sich dabei durch Aufbringung einer Anpaßschicht 4 aus Epoxidharz mit einer Länge von 15 mm, einer Breite von 2 bis 5 mm und einer Dicke von 10 bis 30 µm kompensieren. Die Aufbringung der Anpaßschicht 4 erfolgt dabei je nach festgestellter thermischer Eigenverbiegung beim fertigen Biegewandler 1 direkt auf die äußere Elektrode 9 oder 10.

Bei dem Biegewandler 1 ist die thermische Eigenverbiegung über einen Temperaturbereich von -30 bis +80 °C im wesentlichen vollständig kompensiert. Die Eigenverbiegung beträgt im angegebenen Temperaturbereich weniger als 1 µm/10 °K.

## Patentansprüche

1. Piezoelektrischer Biegewandler (1) mit einem Tragkörper (2) und einer auf den Tragkörper (2) zumindest einseitig aufgebrachten piezoelektrisch aktiven Schicht (3),
**dadurch gekennzeichnet, daß** zur Verringerung der thermischen Eigenverbiegung auf die piezoelektrisch aktive Schicht (3), gegebenenfalls unter Zwischenlage einer Elektrode (9, 10), eine Anpaßschicht (4) mit einem vorgegebenen Volumen aufgebracht ist.

2. Piezoelektrischer Biegewandler (1) nach Anspruch 1, wobei die piezoelektrisch aktive Schicht (3) beidseitig des Tragkörpers (2) und die Anpaßschicht (4) einseitig aufgebracht ist.

3. Piezoelektrischer Biegewandler nach Anspruch 1 oder 2, wobei die Anpaßschicht (4) eine mittels Siebdruck aufgebrachte Schicht ist.

4. Piezoelektrischer Biegewandler nach Anspruch 1 oder 2, wobei die Anpaßschicht (4) ein siebdruckfähiger Kunststoff, insbesondere ein Epoxidharz, ist.

5. Piezoelektrischer Biegewandler nach einem der vorhergehenden Ansprüche, wobei die piezoelektrische Schicht eine Piezokeramik ist.

## Claims

1. Piezoelectric bending transducer (1) having a support body (2) and a piezoelectrically active layer (3) that is applied to the support body (2) at least on one side, **characterised in that** in order to reduce the thermal inherent bending an adaptation layer (4) with a predetermined volume is applied to the piezoelectrically active layer (3), if applicable with interposition of an electrode (9, 10).

2. Piezoelectric bending transducer (1) according to claim 1, wherein the piezoelectrically active layer (3) is applied on both sides of the support body (2), and the adaptation layer (4) is applied on one side.

3. Piezoelectric bending transducer according to claim 1 or 2, wherein the adaptation layer (4) is a layer that is applied by means of screen-printing.

4. Piezoelectric bending transducer according to claim 1 or 2, wherein the adaptation layer (4) is a screen-printable plastics material, in particular an epoxy resin.

5. Piezoelectric bending transducer according to one of the preceding claims, wherein the piezoelectric layer is a piezoceramic material.

## Revendications

1. Transducteur (1) piézoélectrique en flexion, comprenant un support (2) et une couche (3) active du point de vue piézoélectrique, déposée au moins d'un côté sur le support (2),
**caractérisé en ce que**, pour diminuer la flexion thermique propre, il est déposé sur la couche (3) active du point de vue piézoélectrique, le cas échéant avec interposition d'une électrode (9, 10), une couche (4) d'adaptation d'un volume prescrit.

2. Transducteur (1) piézoélectrique en flexion suivant la revendication 1, dans lequel la couche (3) active du point de vue piézoélectrique est déposée des deux côtés du support (2) et la couche (4) d'adaptation d'un côté.

3. Transducteur (1) piézoélectrique en flexion suivant la revendication 1 ou 2, dans lequel la couche (4) d'adaptation est une couche déposée par sérigraphie.

4. Transducteur (1) piézoélectrique en flexion suivant la revendication 1 ou 2, dans lequel la couche (4) d'adaptation est une matière plastique pouvant être sérigraphiée, notamment une résine époxyde.

5. Transducteur (1) piézoélectrique en flexion suivant l'une des revendications précédentes, dans lequel la couche piézoélectrique est une céramique piézoélectrique.
